# EUROPEAN PATENT APPLICATION

(11) **EP 3 848 981 A1**
(43) Date of publication of application: **14.07.2021**
(21) Application number: 20151203.5
(22) Date of filing: 10.01.2020
(51) Int. Cl.: H01L 33/00, H01L 33/62, H01L 33/48, H01L 33/50

(54) **LED MODULE, MOLD AND METHOD FOR MANUFACTURING THE SAME**

(71) Applicant: Lumileds Holding B.V., 1118 CL Schiphol (NL)
(72) Inventor: The designation of the inventor has not yet been filed
(74) Representative: ter Heegde, Paul Gerard Michel

(57) **Abstract**

The present invention generally relates to a method for manufacturing a plurality of LED modules. The method comprises: providing a plate (10); performing a patterning process to the plate (10) to obtain a patterned plate comprising a plurality of substrates (20) for the plurality of LED modules, the patterning process at least creating first gaps (G1) between the plurality of substrates (20); attaching LED dies (30) on the plurality of substrates (20); placing the patterned plate with the LED dies (30) into a mold; overmolding the patterned plate with the LED dies (30) by a molding material for creating barriers (40) bridging the first gaps (G1), the barriers (40) protruding from first surfaces of the substrates (20) where the LED dies (30) are attached, and singulating the plurality of substrates (20) with the LED dies (30) into the plurality of the LED modules by dicing at the first gaps (G1).

## Description

### FIELD OF THE INVENTION

The present invention relates to the field of semiconductor, and particularly to a LED module, a method for manufacturing the LED module, and a mold for use in the method to manufacture the LED module.

### BACKGROUND OF THE INVENTION

Light emitting devices such as LEDs have been widely used in various electrical devices. A typical LED device is in a form of a LED package (also referred to as LED module) including a LED die. For a LED device, a low thermal resistance is always an objective which technical researchers are pursuing. Conventionally, the LED die is bonded to a substrate of the LED module by a silicon-based adhesive material, but the silicon-based adhesive material has a small thermal conductivity of about 0.2∼0.5 W/mK, which is disadvantageous to heat dissipation for the LED module during operation and may result in emitting efficiency degradation. An existing way to improve heat dissipation for the LED module is using epoxy-based silver paste with a thermal conductivity of 10∼25 W/mK to fix the LED die onto the substrate. However, the silver paste is a kind of material that significantly influences light output of the LED module.

### SUMMARY OF THE INVENTION

To alleviate or avoid the defects brought about by the existing material for bonding the LED die to the substrate of the LED module, the inventor of the invention recognizes that the material of Au*ₓ*Sn*_{y}* is a good substitute. The chemical formula "Au*ₓ*Sn*_{y}*" herein means an alloy of Au and Sn, the parameters x and y represent weight percentages of Au and Sn in the alloy material, respectively. Au*ₓ*Sn*_{y}* usually has a relatively high thermal conductivity, e.g., for an alloy of Au₈₀Sn₂₀, it has a thermal conductivity of about 58W/mK. Moreover, as compared to the silver paste, a bonding layer of Au*ₓ*Sn*_{y}* between the LED die and the substrate would have little influence on the light output of the LED module.

However, the inventor further finds that a LED device with a bonding layer of Au*ₓ*Sn*_{y}* is prone to a yellowing phenomenon, and a visible gap is likely to occur between the substrate and a barrier of the LED module surrounding and confining the LED die and related optical layers on the substrate. The yellowing phenomenon and the gap above-mentioned may result in decay in luminous flux of the LED device and be adverse to a service life of the LED device.

The inventor realizes a main factor causing the yellowing phenomenon and the gap is a high temperature condition required for melting the Au*ₓ*Sn*_{y}* material during the process of manufacturing the LED module. For example, the temperature needed for melting Au₈₀Sn₂₀ is as high as 280∼290 degree Celsius. The material of the barrier tends to become yellow after going through the high temperature condition. In view of this, the present invention provides a method for manufacturing the LED module so as to eliminate or at least alleviate one or more of the above mentioned defects.

According to an embodiment of the invention, a plurality of LED modules could be manufactured at the same time during a same process. The method for manufacturing the plurality of LED modules comprises: providing a plate; performing a patterning process to the plate to obtain a patterned plate comprising a plurality of substrates for the plurality of LED modules, the patterning process at least creating first gaps between the plurality of substrates; attaching LED dies on the plurality of substrates; placing the patterned plate with the LED dies into a mold; overmolding the patterned plate with the LED dies by a molding material for creating barriers bridging the first gaps, the barriers protruding from first surfaces of the substrates where the LED dies are attached, and singulating the plurality of substrates with the LED dies into the plurality of the LED modules by dicing at the first gaps.

As can be clearly appreciated from this embodiment, during the process of overmolding the patterned plate with the LED dies by the molding material, the LED dies have already been attached on the substrates. That is, attaching the LED dies on the substrates is performed before the overmolding step. As a result, the molding material included in a finished LED module would not be affected by the temperature condition required for attaching the LED dies on the substrates. In this way, the yellowing phenomenon and the above-mentioned gap problem can be eliminated or at least alleviated.

As previously discussed, the alloy Au*ₓ*Sn*_{y}* is a good substitute for the conventional material for bonding the LED die to the substrate, therefore, in an embodiment, the attaching LED dies on the plurality of substrates comprises bonding the LED dies to the plurality of substrates by Au*ₓ*Sn*_{y}*, where the parameter x represents weight percentage of Au, and the parameter y represents weight percentage of Sn. In an example, x is 80±5%, *y* is 20±5%, and a sum of x and y is 100%. Moreover, the alloy material Au*ₓ*Sn*_{y}* is just an example material for bonding the LED die to the substrate, any other material having a relatively high thermal conductivity and less influence on the light output can be used in the LED module.

In an embodiment, the bonding the LED dies to the plurality of substrates by Au*ₓ*Sn*_{y}* comprises: dipping flux onto the plurality of substrates and depositing Au*ₓ*Sn*_{y}* onto the LED dies; placing the LED dies with Au*ₓ*Sn*_{y}* on the flux, and melting Au*ₓ*Sn*_{y}* with the flux so that the LED dies are bonded to the plurality of substrates. As an example, the alloy of Au*ₓ*Sn*_{y}* may be deposited onto bottom surfaces of the LED dies, then the LED dies with the alloy of Au*ₓ*Sn*_{y}* are placed on the flux dipped onto the substrates.

The material for the plate above-mentioned is not limited herein. In an embodiment, the plate is a conductive plate, and the patterning process further creates a first conductive patch and a second conductive patch from the conductive plate for each of the plurality of substrates, the first conductive patch and the second conductive patch being spaced from each other by a second gap.

In case the plate is a conductive plate such as a copper plate, the overmolding the patterned plate with the LED dies by the molding material may comprise: filling the second gap with the molding material to create a mechanical connection between the first conductive patch and the second conductive patch for each of the plurality of the substrates. In this case, the first conductive patch and the second conductive patch mechanically connected by the molding material in the second gap together form a substrate for supporting the LED die of the LED module.

Further, in an embodiment, the method for manufacturing the LED modules further comprises: electrically connecting the first conductive patch and the second conductive patch with a cathode and an anode of each LED die respectively by conductive wires, and depositing a light conversion layer covering the conductive wires and the LED die. The material for the light conversion layer can be selected depending on the light emitted from the LED die and a desired color of light exiting the LED modules, which is well-known and, thus, will not be described herein.

In an embodiment, the plate is a non-conductive plate, the patterning process further creates at least two through holes in each substrate of the plurality of substrates. As an example, the plate may be a ceramic plate, the method for manufacturing the LED modules may further comprise: forming two conductive pads on a second surface of the substrate opposite to the first surface, and electrically connecting an anode and a cathode of each of the LED dies with the two conductive pads respectively via the two through holes. The through holes in the non-conductive plate and conductive pads make it possible that the LED die can be electrically connected to an external circuit and powered.

In an embodiment, the molding material comprises an epoxy molding compound. The epoxy molding compound may appear white, which is beneficial for reducing light absorption as much as possible. But the protection scope of the invention is not so limited. In other embodiments, materials in other colors may be used as the molding material.

In an embodiment, the method for manufacturing the LED modules further comprises: coating light reflection material onto a surface of the patterned plate prior to attaching the LED dies on the plurality of substrates.

In an embodiment, the mold used in the method of the above embodiments comprises a tooling plate and a supporting plate, a first surface of the tooling plate comprises a plurality of first recesses separated from each other, the placing the patterned plate with the LED dies into the mold comprises: placing the patterned plate with the LED dies on the supporting plate, and clamping the tooling plate and the supporting plate together, with the first surface of the tooling plate facing the supporting plate and the plurality of first recesses aligning with the LED dies respectively, such that the plurality of first recesses of the tooling plate and the patterned plate on the supporting plate form a plurality of first cavities and each of the LED dies is enclosed in a respective one of the plurality of first cavities.

Another embodiment of the invention proposes a LED module comprising a LED die and a substrate for supporting the LED die, the LED module further comprises an Au*ₓ*Sn*_{y}* layer between the LED die and the substrate, the Au*ₓ*Sn*_{y}* layer being configured to bond the LED die to the substrate. Since the Au*ₓ*Sn*_{y}* layer has a relatively high thermal conductivity, the LED module may have a good heat dissipation effect when in operation.

In an embodiment, the substrate comprises a first conductive patch and second conductive patch electrically connected to an anode and a cathode of the LED die respectively, and the first conductive patch and the second conductive patch are electrically isolated from each other by a molding material.

In an embodiment, the LED module further comprises a barrier surrounding and protruding from a first surface of the substrate where the LED die is bonded, and the barrier is made from the molding material.

Yet another embodiment of the invention provides a mold for use in the method for manufacturing the LED module according to any of the above embodiments, the mold comprises a supporting plate and a tooling plate, a first surface of the tooling plate comprises a plurality of first recesses separated from each other, the supporting plate and the tooling plate are capable of being clamped together such that the plurality of first recesses of the tooling plate and the supporting plate form a plurality of second cavities separated from each other. In the method for manufacturing the LED module proposed by the embodiments herein, since the overmolding step is carried out after the LED dies are attached on the substrates, the LED dies need to be protected during the overmolding process. The mold proposed by the embodiment can provide the second cavities for enclosing the LED dies in order to prevent the LED dies on the substrates from being contacting the molding material.

In an embodiment, the first surface of the tooling plate further comprises a plurality of annular second recesses that are separated from the plurality of first recesses, the plurality of annular second recesses are in communication with each other and each of the plurality of the annular second recesses surrounds a respective one of the plurality of first recesses.

Some embodiments of the invention are generally described above, but it will be appreciated by a person of ordinary skill in the art that two or more of the technical features of the above disclosed embodiments of the invention may be combined in any way deemed useful. Different modifications and variations of the above embodiments of LED modules can be conceived by the person of ordinary skill in the art based on the teaching of the present disclosure.

### BRIEF DESCRIPTION OF THE DRAWINGS

These and other aspects of the present invention will be described now in more detail, with reference to the appended drawings showing embodiments and forming a part of the present invention. Specifically, in the drawings:
- Figs. 1a to 11: schematically show some steps of a method for manufacturing a plurality of LED modules according to an embodiment of the invention.
- Fig. 2: illustrates a sectional view of a finished LED module according to an embodiment of the invention.
- Fig. 3: illustrates a patterned plate during the processes of a method for manufacturing a plurality of LED modules according to another embodiment of the invention.
- Fig. 4: illustrates a sectional view of a finished LED module according to another embodiment of the invention.
- Fig. 5: illustrates a top perspective view of a tooling plate of a mold used in the method for manufacturing a plurality of LED modules according to an embodiment of the invention.
- Fig.6: illustrates a cross sectional view of a mold whose tooling plate and supporting plate are clamped together.

### DETAILED DESCRIPTION OF THE EMBODIMENTS

While the present invention is susceptible of embodiments in many different forms, only some specific embodiments are shown in the drawings and will be described in detail herein, with the understanding that the description is to be considered as explanation of the basic principle of the invention and not intended to limit the invention only to the specific embodiments shown and described herein.

It should be noted that various components in different figures are not drawn to scale. Besides, relative positional relationships between individual elements shown in the figures are only used to illustrate the basic principles of the invention and should not be considered to limit the scope of the invention.

In the following, the method for manufacturing LED modules proposed by the invention will be described in details by way of examples.

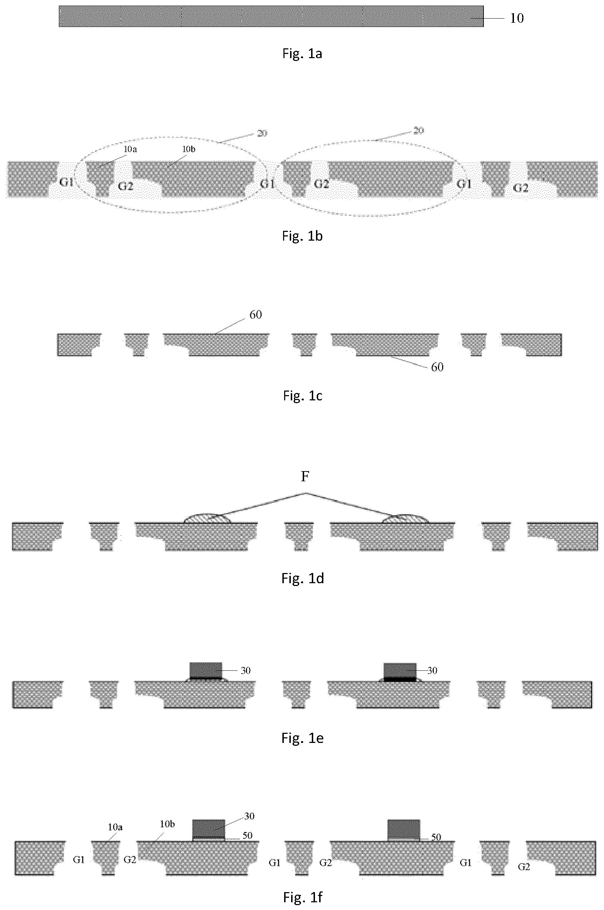

Figs. 1a to 1l schematically show some steps involved in the method for manufacturing a plurality of LED modules. Referring to Fig. 1a, a plate 10 is firstly provided, the plate 10 may be a conductive plate such as a copper plate. Alternatively, the plate 10 could be a non-conductive plate such as a ceramic plate. The plate 10 is then subjected to a patterning process, thereby obtaining a patterned plate. As shown in Fig. 1b, a metal plate is patterned to obtain a patterned plate comprising a plurality of substrates 20 for the plurality of LED modules, the patterning process for the metal plate creates first gaps G1 between the plurality of substrates 20, that is, the plurality of substrates 20 are spaced from each other by the first gaps G1. Moreover, the patterning process may further create second gaps G2 to form a first conductive patch 10a and a second conductive patch 10b from the conductive plate 10 for each of the plurality of substrates 20, the first conductive patch 10a and the second conductive patch 10b of each substrate 20 are spaced from each other by the second gap G2. The first conductive patch 10a and the second conductive patch 10b in a finished LED module may serve as components for electrically connecting the LED module with an external circuit. The patterning process may involve any appropriate technique for the plate 10 to create the first gaps G1 and the second gaps G2, including but not limited to a chemical wet etching process.

Optionally, in an embodiment, one or more surfaces of the patterned plate may be coated with a light reflection layer 60, as shown in Fig. 1c. Coating the light reflection material 60 onto the surfaces of the patterned plate is advantageous to improve utilization efficiency of light for a finished LED module. The light reflection material 60 includes but is not limited to silver.

As previously discussed, the material of Au*ₓ*Sn*_{y}* has advantages of having a relatively high thermal conductivity and less adverse effect on the light output of the LED module, therefore, in an embodiment, the LED dies are bonded to the plurality of substrates 20 of the LED modules by means of the material of Au*ₓ*Sn*_{y}*. As an example, the material of Au*ₓ*Sn*_{y}* is firstly deposited on bottom surfaces of the LED dies, meanwhile, some flux F may be dipped onto a region of a surface of each substrate 20 where the LED die is to be attached on the substrate 20, as shown in Fig. 1d. Subsequently, the LED dies 30 with the material of Au*ₓ*Sn*_{y}* are placed on the flux F, as shown in Fig. 1e. Next, the patterned plate with the LED dies 30 experiences a high temperature condition to melt Au*ₓ*Sn*_{y}* with the flux, so that the LED dies 30 are bonded to the substrates 20. As an example, the patterned plate with the LED dies 30 may go through a reflow oven, which makes the material of Au*ₓ*Sn*_{y}* melted. In this way, the LED dies 30 may be well fixed onto the surfaces of the substrates 20 once the melted Au*ₓ*Sn*_{y}* is cooled. As shown in Fig.1f, an Au*ₓ*Sn*_{y}* layer 50 is formed to bond each LED die 30 to its substrate 20.

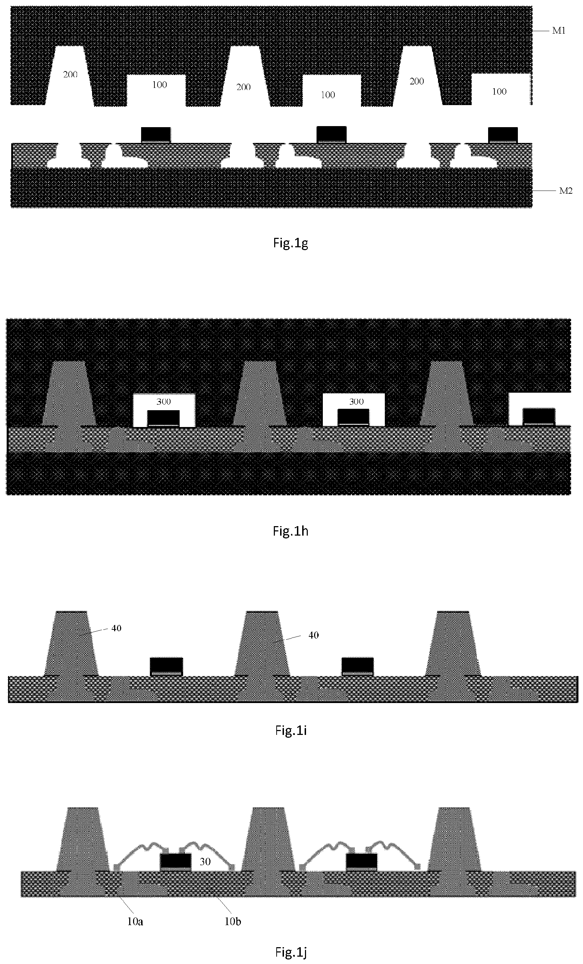

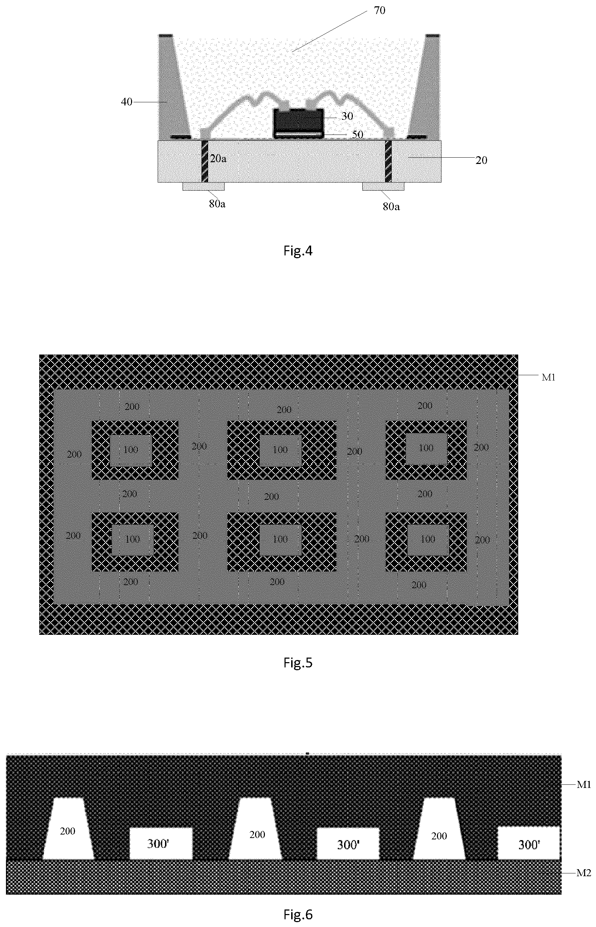

Figs. 1g to 1i illustrate an overmolding process for the plurality of substrates 20 with the LED dies 30. In an example, the overmolding process is performed for creating barriers 40 bridging the first gaps G1 and filling the second gaps G2 to form a mechanical connection between the first conductive patch 10a and the second conductive patch 10b for each of the plurality of the substrates 20. In an embodiment, the mold comprises a tooling plate M1 and a supporting plate M2, Figs. 1g and 1h show cross-sectional views of the tooling plate M1 and the supporting plate M2. A first surface of the tooling plate M1 comprises a plurality of first recesses 100 separated from each other. The first surface of the tooling plate M1 further comprises a plurality of annular second recesses 200 that are separated from the plurality of first recesses 100. The plurality of annular second recesses 200 are in communication with each other and each of the plurality of the annular second recesses 200 surrounds a first recess 100 of the plurality of first recesses 100. The details of the mold will be further discussed later in connection with Figs. 5 and 6 below. Referring to Fig. 1g, the patterned plate with the LED dies 30 is placed on the support plate M2 of the mold, in Fig. 1h, the tooling plate M1 and the supporting plate M2 are clamped together so that the first surface of the tooling plate M1 faces the supporting plate M2 and the plurality of first recesses 100 align with the LED dies 30 respectively. As a result, the plurality of first recesses 100 of the tooling plate M1 and the patterned plate on the supporting plate M2 form a plurality of first cavities 300 and each of the LED dies 30 can be enclosed in a respective first cavity of the plurality of first cavities 300.

In an example, each of the plurality of annular second recesses 200 is substantially aligned with the first gaps G1 around a respective substrate 20 in the patterned plate. In this way, the second recesses 200 of the tooling plate M1 and the patterned plate together with the supporting plate M2 may form a plurality of additional cavities that are in communication with each other. Actually, the plurality of second gaps G2 are also in communication with the additional cavities. On this basis, the molding material such as an epoxy molding compound could be injected into the above-mentioned additional cavities but not into the first cavities 300. As a result, the plurality of second recesses 200, the first gaps G1 and the second gaps G2 are all filled with the molding material, as shown in Fig. 1h. Therefore, the barriers 40 bridging the first gaps G1 are created and the barriers 40 protrude from the first surfaces of the substrates 20 where the LED dies 30 are attached. The first conductive patch10a and the second conductive patch 10b for each of the plurality of the substrates 20 are mechanically connected by the molding material in the second gap G2. Fig. 1i illustrates that where the mold has been taken away after the injected molding material has cured.

Fig. 1j illustrates that each LED die 30 is electrically connected to the first conductive patch 10a and the second conductive patch 10b of the substrate 20. Specifically, an anode and a cathode of each LED die 30 are connected to the first conductive patch 10a and the second conductive patch 10b via conductive wires, respectively.

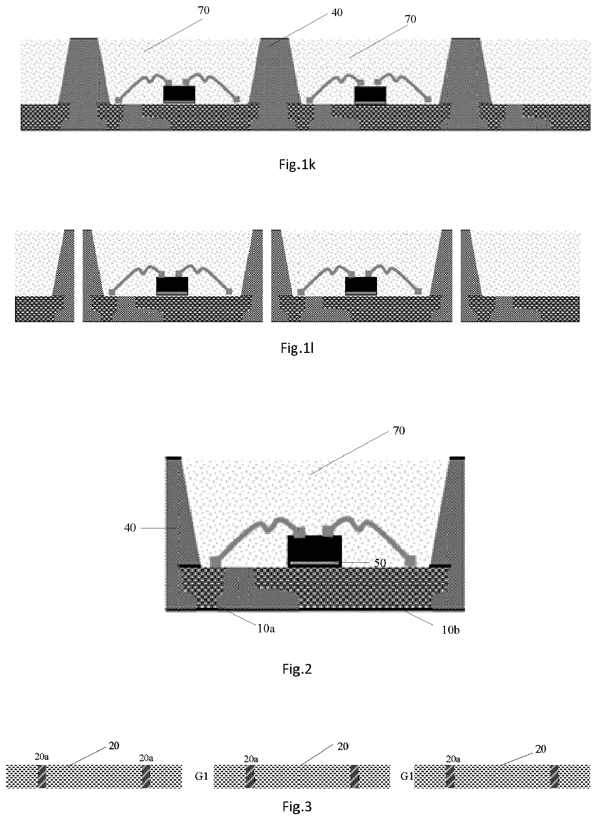

In Fig. 1k, a light conversion material is dispensed on the substrate 20 to cover the LED dies and the conductive wires. As a result, a light conversion layer 70 is formed on each substrate 20, and the light conversion layer 70 is confined by the barrier 40. The light conversion material includes but is not limited to phosphor gel. Finally, as shown in Fig. 1l, theplurality of substrates 20 with the LED dies 30 are singulated into the plurality of the LED modules by dicing at the first gaps G1.

It can be well appreciated that although Figs. 1a to 1l show some detailed steps of the method for manufacturing the LED modules according to an embodiment of the invention, it does not mean that all the illustrated steps must be included in the process of manufacturing the LED modules, e.g., coating the patterned plate with light reflection material shown in Fig. 1b may be not necessary in some situations. Conversely, some additional steps not discussed herein may be involved in the method for manufacturing the LED modules. Fig.2 schematically shows a cross-sectional view of a single LED module of the plurality of LED modules manufactured by the above method embodiment. The single LED module comprises a LED die 30 and a substrate for supporting the LED die 30. The LED module further comprises an Au*ₓ*Sn*_{y}* layer 50 between the LED die 30 and the substrate, and the LED die is bonded to the substrate by the Au*ₓ*Sn*_{y}* layer 50. Due to the property of the Au*ₓ*Sn*_{y}* material having a relatively high thermal conductivity, the LED module may achieve a good heat dissipation effect when in operation, meanwhile, the light output of the LED module will not be significantly affected by the Au*ₓ*Sn*_{y}* layer 50.

In the embodiment of Fig. 2, the substrate comprises a first conductive patch 10a and a second conductive patch 10b electrically connected to an anode and a cathode of the LED die 30 respectively, and the first conductive patch 10a and the second conductive patch 10b are electrically isolated from each other by the molding material. The LED module further comprises a barrier 40 surrounding and protruding from a first surface of the substrate where the LED die 30 is bonded, and the barrier 40 is made from the molding material. When the LED module is mounted onto a printed circuit board, the first conductive patch 10a and the second conductive patch 10b may enable an electrical connection between the LED module and the printed circuit board. That is to say, external voltage could be supplied to the anode and cathode of the LED die respectively through the first and second patches 10a, 10b, and the conductive wires.

Though, in the embodiment illustrated in Figs. 1a to 1l, the plate is a metal plate, in other embodiments, the plate 10 may be a non-conductive plate such as a ceramic plate. The patterning process performed for the ceramic plate 10 may be different from the process for the metal plate. As shown in Fig. 3, in addition to the first gaps G1 between the plurality of substrates 20, the patterning process for the ceramic plate further creates at least two through holes 20a in each substrate 20. The patterned ceramic plate may go through a similar overmolding process to form the barrier 40 surrounding and protruding from a first surface of the substrate 20 where the LED die 30 is attached. In this situation, the method may further comprise forming two conductive pads 80a on a second surface of the substrate 20 opposite to the first surface, and electrically connecting an anode and a cathode of each of the LED dies 30 with the two conductive pads 80a respectively via the two through holes 20a. Other steps involved in manufacturing LED modules containing the non-conductive substrate may be similar to the above-described steps for manufacturing LED modules including the conductive patches, which would not be repeated herein.

Fig. 4 illustrates a cross-sectional view of a finished single LED module where the substrate 20 is a ceramic substrate. In this example, the LED die 30 can be powered through the conductive pads 80a, the through holes 20a and the conductive wires connected with the LED die 30.

Another embodiment of the invention proposes a mold for use in the method of the foregoing embodiments for manufacturing the LED modules. The mold will be specifically described in connection with Fig. 5 and Fig. 6. The mold comprises a supporting plate M2 and a tooling plate M1. Fig. 5 schematically shows a top perspective view of the tooling plate M1, and Fig. 6 schematically shows a cross sectional view of the mold when the supporting plate M2 and the tooling plate M1 are clamped together. Referring to Fig. 5 and Fig. 6, a first surface of the tooling plate M1 comprises a plurality of first recesses 100 separated from each other, the supporting plate M2 and the tooling plate M1 are capable of being clamped together such that the plurality of first recesses 100 of the tooling plate M1 and the supporting plate M2 form a plurality of second cavities 300' separated from each other. The second cavities 300' shown in Fig. 6 may be considered similar to the first cavities 300 shown in Fig. 1h if the patterned plate between the tooling plate M1 and the supporting plate M2 in Fig. 1h is neglected.

Referring to Figs. 5 and 6, the mold further comprises a plurality of annular second recesses 200 in the first surface of the tooling plate M1, the plurality of annular second recesses 200 are separated from the plurality of first recesses 100, but all the plurality of annular second recesses 200 are in communication with each other. Moreover, each first recess 100 is actually surrounded by a respective annular second recess of the plurality of the annular second recesses 200. The mold proposed by the embodiment of the invention is particularly useful in the method for manufacturing the LED modules according to the foregoing embodiments. Specifically, the LED dies attached on the substrates would not be affected during the overmolding process, since they can be enclosed in the second cavities formed by the tooling plate and the supporting plate and the injected molding material would not flow into the second cavities. Furthermore, the plurality of annular second recesses in communication with each other makes it practicable to create all the barriers bridging the first gaps all at once. Therefore, the plurality of LED modules can be manufactured in an efficient way.

It should also be noted that the above-mentioned embodiments illustrate rather than limit the present invention, and that the person of ordinary skill in the art will be able to design many alternative embodiments without departing from the scope and spirit of the present invention. The scope of the present invention is limited only by the accompanying claims.

Furthermore, in the claims, any reference signs placed between parentheses shall not be construed as limiting the claims. Use of the verb "comprise" and its conjugations does not exclude the presence of elements or steps other than those stated in a claim. The article "a" or "an" preceding an element does not exclude the presence of a plurality of such elements. Also, references to first, second etc. are merely to be considered as labels and do not imply or describe any ordering, sequence, relation or properties of the features prefixed by these terms. The mere fact that certain measures are recited in mutually different dependent claims does not indicate that a combination of these measures cannot be used to advantage.

### LIST OF REFERENCE NUMERALS:

- 10: plate
- 10a: first conductive patch
- 10b: second conductive patch
- 20: substrate
- 20a: through hole
- 30: LED die
- 40: barrier
- 50: Au*ₓ*Sn*_{y}* layer
- 60: light reflection layer
- 70: light conversion layer
- 80a: conductive pad
- G1: first gap
- G2: second gap
- F: flux
- M1: tooling plate
- M2: supporting plate
- 100: first recess
- 200: second recess
- 300: first cavity
- 300': second cavity

## Claims

1. A method for manufacturing a plurality of LED modules, comprising:
- providing a plate (10);
- performing a patterning process to the plate (10) to obtain a patterned plate comprising a plurality of substrates (20) for the plurality of LED modules, the patterning process at least creating first gaps (G1) between the plurality of substrates (20);
- attaching LED dies (30) on the plurality of substrates (20);
- placing the patterned plate with the LED dies (30) into a mold;
- overmolding the patterned plate with the LED dies (30) by a molding material for creating barriers (40) bridging the first gaps (G1), the barriers (40) protruding from first surfaces of the substrates (20) where the LED dies (30) are attached, and
- singulating the plurality of substrates (20) with the LED dies (30) into the plurality of the LED modules by dicing at the first gaps (G1).

2. The method according to claim 1, wherein the attaching LED dies (30) on the plurality of substrates (20) comprises bonding the LED dies (30) to the plurality of substrates (20) by Au*ₓ*Sn*_{y}* (50), wherein *x* represents weight percentage of Au, and *y* represents weight percentage of Sn.

3. The method according to claim 2, wherein the bonding the LED dies (30) to the plurality of substrates (20) by Au*ₓ*Sn*_{y}* (50) comprises:
- dipping flux onto the plurality of substrates (20) and depositing Au*ₓ*Sn*_{y}* onto the LED dies (30);
- placing the LED dies (30) with Au*ₓ*Sn*_{y}* on the flux, and
- melting Au*ₓ*Sn*_{y}* with the flux so that the LED dies (30) are bonded to the plurality of substrates (20).

4. The method according to claim 1, wherein the plate (10) is a conductive plate, and the patterning process further creates a first conductive patch (10a) and a second conductive patch (10b) from the conductive plate (10) for each of the plurality of substrates (20), the first conductive patch (10a) and the second conductive patch (10b) being spaced from each other by a second gap (G2).

5. The method according to claim 4, wherein the overmolding the patterned plate with the LED dies (30) by the molding material comprises: filling the second gap (G2) with the molding material to create a mechanical connection between the first conductive patch (10a) and the second conductive patch (10b) for each of the plurality of the substrates (20).

6. The method according to claim 5, further comprising:
- electrically connecting the first conductive patch (10a) and the second conductive patch (10b) with a cathode and an anode of each LED die (30) respectively by conductive wires, and
- depositing a light conversion layer (70) covering the conductive wires and the LED die (30).

7. The method according to claim 1, wherein the plate (10) is a non-conductive plate, the patterning process further creates at least two through holes (20a) in each substrate of the plurality of substrates (20), wherein the method further comprises:
- forming two conductive pads (80a) on a second surface of the substrate (20) opposite to the first surface, and
- electrically connecting an anode and a cathode of each of the LED dies (30) with the two conductive pads (80a) respectively via the two through holes (20a).

8. The method according to any one of claims 1 to 7, wherein the molding material comprises an epoxy molding compound.

9. The method according to any one of claims 1 to 7, further comprising:
coating light reflection material (60) onto a surface of the patterned plate prior to attaching the LED dies (30) on the plurality of substrates (20).

10. The method according to any one of claims 1 to 7, wherein the mold comprises a tooling plate (M1) and a supporting plate (M2), a first surface of the tooling plate (M1) comprises a plurality of first recesses (100) separated from each other, wherein the placing the patterned plate with the LED dies (30) into the mold comprises:
- placing the patterned plate with the LED dies (30) on the supporting plate (M2), and
- clamping the tooling plate (M1) and the supporting plate (M2) together, with the first surface of the tooling plate (M1) facing the supporting plate (M2) and the plurality of first recesses (100) aligning with the LED dies (30) respectively, such that the plurality of first recesses (100) of the tooling plate (M1) and the patterned plate on the supporting plate (M2) form a plurality of first cavities (300) and each of the LED dies (30) is enclosed in a respective one of the plurality of first cavities (300).

11. A LED module, comprising a LED die (30) and a substrate (20) for supporting the LED die (30), wherein the LED module further comprises a Au*ₓ*Sn*_{y}* layer (50) between the LED die (30) and the substrate (20), the Au*ₓ*Sn*_{y}* layer (50) being configured to bond the LED die (30) to the substrate (20).

12. The LED module according to claim 11, wherein the substrate (20) comprises a first conductive patch (10a) and a second conductive patch (10b) electrically connected to an anode and a cathode of the LED die (30) respectively, and the first conductive patch (10a) and the second conductive patch (10b) are electrically isolated from each other by a molding material.

13. The LED module according to claim 12, wherein the LED module further comprises a barrier (40) surrounding and protruding from a first surface of the substrate (20) where the LED die (30) is bonded, and the barrier (40) is made from the molding material.

14. A mold for use in the method of claim 10 for manufacturing the LED module according to claim 11, the mold comprising a supporting plate (M2) and a tooling plate (M1),
wherein a first surface of the tooling plate (M1) comprises a plurality of first recesses (100) separated from each other,
wherein the supporting plate (M2) and the tooling plate (M1) are capable of being clamped together such that the plurality of first recesses (100) of the tooling plate (M1) and the supporting plate (M2) form a plurality of second cavities (300') separated from each other.

15. The mold according to claim 14, wherein the first surface of the tooling plate (M1) further comprises a plurality of annular second recesses (200) that are separated from the plurality of first recesses (100), the plurality of annular second recesses (200) are in communication with each other and each of the plurality of the annular second recesses (200) surrounds a respective one of the plurality of first recesses (100).
